# EUROPEAN PATENT SPECIFICATION

(11) **EP 2 322 992 B1**
(45) Date of publication and mention of the grant of the patent: **24.07.2013**
(21) Application number: 11153593.6
(22) Date of filing: 28.11.2000
(51) Int. Cl.: G03F 1/30

(54) **Phase shift masking for complex patterns**
Phasenschiebermaskierung für komplexe Muster
Masque de décalage de phase pour motifs complexes

(30) Priority: 05.07.2000 US 215938 P; 26.09.2000 US 669359
(43) Date of publication of application: 18.05.2011
(62) Divisional of application: 00992248.5
(73) Proprietor: Synopsys, Inc., Mountain View, CA 94043 (US)
(72) Inventor: Pierrat, Christophe, Santa Clara, CA 95054 (US)
(74) Representative: Davies, Simon Robert

(56) References cited:
- JP-A- 10 010 700
- US-A- 5 362 584
- US-A- 5 496 666
- US-A- 5 523 186
- US-A- 5 837 405
- US-A- 5 989 756

## Description

### BACKGROUND OF THE INVENTION

### Field of the Invention

The present invention relates to manufacturing small dimension features of objects, such as integrated circuits, using photolithographic masks. More particularly, the present invention relates to the application of phase shift masking to complex layouts for integrated circuits and similar objects.

### Description of Related Art

Phase shift masking, as described in United States Patent No. 5,858,580, has been applied to create small dimension features in integrated circuits. Typically the features have been limited to selected elements of the design, which have a small, critical dimension. Although manufacturing of small dimension features in integrated circuits has resulted in improved speed and performance, it is desirable to apply phase shift masking more extensively in the manufacturing of such devices. However, the extension of phase shift masking to more complex designs results in a large increase in the complexity of the mask layout problem. For example, when laying out phase shift areas on dense designs, phase conflicts will occur. One type of phase conflict is a location in the layout at which two phase shift regions having the same phase are laid out in proximity to a feature to be exposed by the masks, such as by overlapping of the phase shift regions intended for implementation of adjacent lines in the exposure pattern. If the phase shift regions have the same phase, then they do not result in the optical interference necessary to create the desired effect. Thus, it is necessary to prevent inadvertent layout of phase shift regions in phase conflict.

Another problem with laying out complex designs which rely on small dimension features, arises because of isolated exposed spaces which may have narrow dimension between unexposed regions or lines.

Because of these and other complexities, implementation of a phase shift masking technology for complex designs will require improvements in the approach to the design of phase shift masks, and new phase shift layout techniques.

JP 10 010700A provides a photomask with which isolated patterns and periodic patterns coexist and the accurate transfer of the isolated patterns similar to the periodic patterns is possible and a process for producing such a photomask. The photomask of a halftone phase shift system is provided with light shielding films near openings of the isolated pattern parts and is imparted with periodicity, by which the depth of focus is expanded. The periodic patterns of an ordinary binary mask are provided with transmittance control films to correct for proximity effects.

US 5,523,186 provides a photolithographic technique and apparatus involving two exposures and the sectioning of a first original mask opening that has segments which conflict with a second original mask opening.

### SUMMARY OF THE INVENTION

The present invention provides a method according to claim 1 and its dependent claims.

Other aspects and advantages of the present invention can be understood with review of the figures, the detailed description and the claims which follow.

### BRIEF DESCRIPTION OF THE FIGURES

Fig. 1 illustrates a binary mask and Fig. 2 illustrates a phase shift mask according to a prior art phase shift masking technique.
Fig. 3 is a plot of the intensity profile of an exposure made using the masks of Figs. 1 and 2 according to the prior art.
Fig. 4 illustrates a binary mask, and Fig. 5 illustrates a phase shift mask according to the present invention for implementing the same shape as implemented with Figs. 1 and 2.
Fig. 6 is a plot of the intensity profile of an exposure made using the mask of Figs. 4 and 5 according to the present invention.
Fig. 7 is a binary mask, and Fig. 8 is a phase shift mask for implementation of a feature comprising three intersecting line segments according to an example which is presented for illustration.
Fig. 9 is a plot of the intensity profile of an exposure made using the masks of Figs. 7 and 8.
Fig. 10 is a binary mask, and Fig. 11 is a phase shift mask for implementation of a feature comprising five intersecting line segments according to an example which is presented for illustration.
Fig. 12 illustrates a phase shift mask for implementation of a double "T" structure.
Fig. 13 illustrates an alternative phase shift mask for implementation of a double "T" structure according to the present invention.
Fig. 14 illustrates one example of the layout of a phase shift mask according to the present invention for a complex pattern.
Figs. 15A and 15B illustrate the layout, a simulation and contour plots of a prior art phase shift mask for implementation of a dense array of capacitor plates on integrated circuit.
Figs. 16A and 16B illustrates the layout, a simulation, and contour plots of the phase shift mask for implementation of a dense array of capacitor plates on an integrated circuit according to the present invention.
Fig. 17A illustrates a phase shift mask having sub-resolution assist features, for implementation of an exposure pattern as shown in Fig. 17B.
Fig. 17B shows an exposure pattern which results from the phase shift mask of Fig. 17A, and an exposure pattern which would result from the phase shift mask of Fig. 17A without the assist features.
Fig. 18 is a flow chart of a process for producing layout files, and phase shift mask and manufacturing integrated circuits according to the present invention.

### DETAILED DESCRIPTION

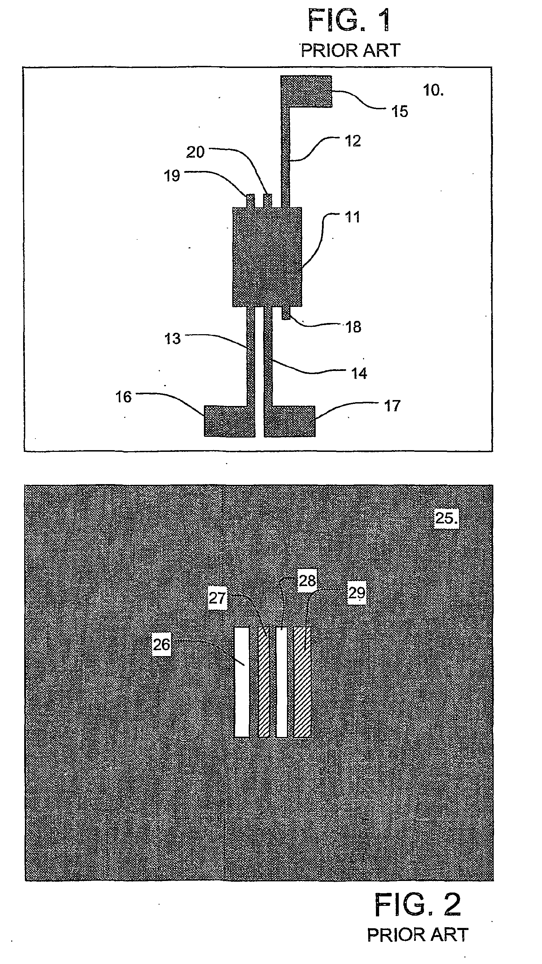

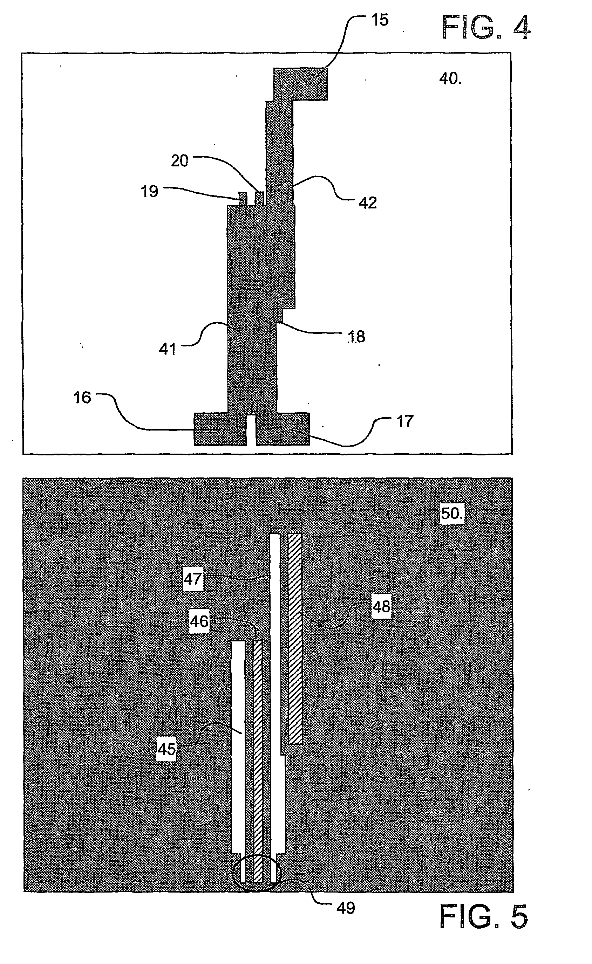

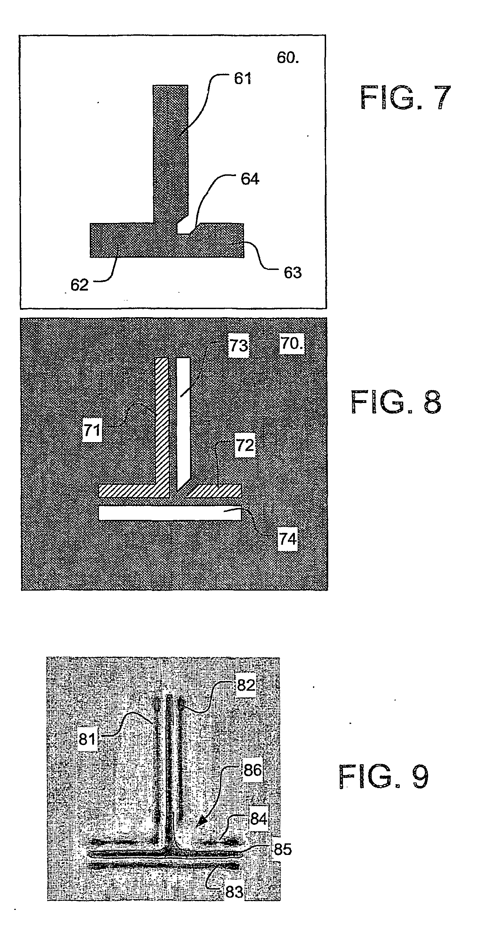

A detailed description of the present invention is provided with respect Figs. 1-19. Figs. 1-3 illustrate problems associated with the layout and manufacturing of small dimension features according to the prior art. Figs 4-6 illustrate an approach to improving the layout and manufacturing of the small dimension features shown in Figs 1-3 according to the present invention. Figs. 7-9 illustrate additional features and techniques.

Fig. 1 shows a binary mask for use in combination with an opaque field phase shift mask as shown in Fig. 2. The binary mask of Fig. 1 includes an opaque feature within a clear field 10. The opaque feature includes a blocking region 11 which corresponds to the features to the features, i.e. transistor gates in an active region of a device, formed using the phase shift structures of Fig.2. Narrow lines, 12, 13 and 14 extend from the blocking region 11 to respective flag shaped elements 15, 16, 17. The narrow lines 12, 13, 14 in this example each extend through the blocking region 11, resulting in respective extension portions 18, 19, 20. The phase shift mask of Fig. 2 is formed within the opaque field 25, inside which zero degree phase shift regions 26, 27 and 180 degree phase shift regions 28, 29 are formed. The phase shift regions result in the printing of fine lines on the transitions between zero degree region 26 and 180 degree region 28, between 180 degree region 28 and zero degree region 27, and between zero degree region 27 and 180 degree region 29. These fine lines are coupled with the line 12, 13, 14 in the binary mask of Fig. 1 for interconnection, while the blocking region 11 prevents exposure of the fine lines during the exposure using the binary mask.

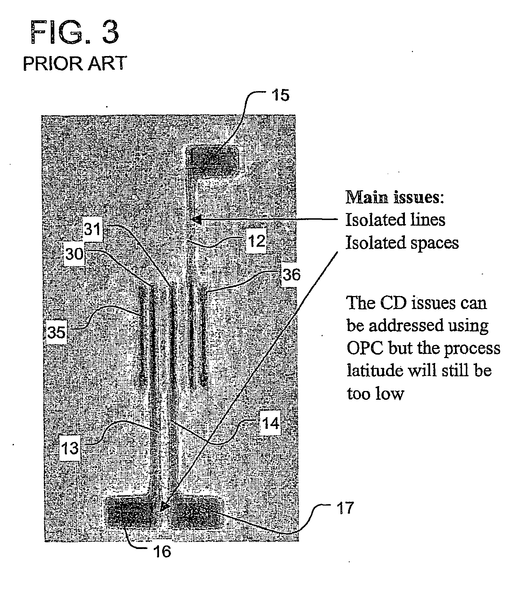

Fig. 3 shows the resulting fine lines 30, 31, 32 in the active region of the layout. The long narrow line 12, 13, 14 interconnect the fine lines 30, 31, 32 with the flag shaped features 15, 16, 17. In the Fig., the regions 35 and 36 do not print, but are higher intensity regions which show dark as artifacts of black and white printing of the color image generated using a simulation program.

Issues associated with this technique include the poor quality of the image of isolated lines, such as long line 12, and of the narrow spaces, such as between the flag shaped features 16 and 17. Classical optical proximity correction techniques can be applied to improve dimensional control of these images, however such processes according to the prior art fo not improve process latitude, making the structures difficult to manufacture.

Figs. 4 and 5 show the binary mask and phase shift made implemented according to an example which is presented for illustration, extending phase shift techniques to the more complex circuit pattern beyond the transistor gates in the active region. The binary mask of Fig. 4 is formed in a clear field 40. It includes blocking features 41 and 42. The pattern elements which are common with Fig. 1 have like numbers, so the extensions 18, 19, 20 and the flag shaped features 15, 16, 17 have the same reference numbers. A corresponding phase shift mask shown in Fig. 5 includes an opaque field 50. The phase shifting regions have been extended along the entire lengths of the lines excluding the extensions 18, 19, 20 in this example. In addition, phase shifting in the region 49 is used to assist the definition of the edges of the flag shaped regions 16 and 17 in the narrow space between them. Thus, zero degree phase shift regions 45 and 47 are formed, and 180 degree phase shift regions 46 and 48 are formed. The phase shift regions 45, 46 and 47 extend to the lower edges 51, 52 of the flag shaped regions 16, 17.

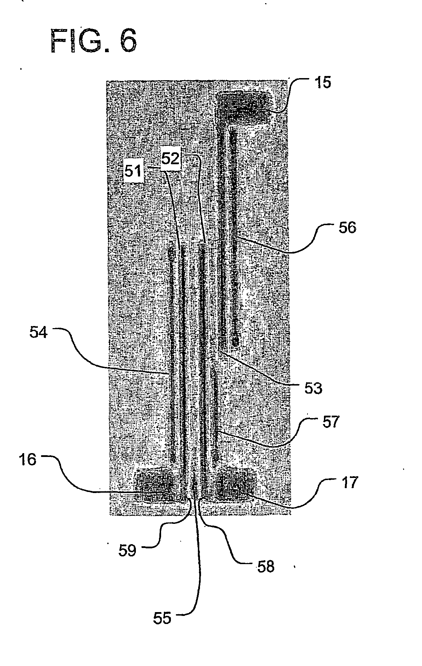

A simulation of image resulting from application of the masks of Figs. 4 and 5, is shown in Fig. 6, in which the regions 54, 55, 56 and 57 are nonprinting artifacts as mentioned above of the black and white printing of the color simulation image. The long lines corresponding to the lines 12, 13, 14 of Fig. 1 are printed entirely using phase shifting, so that quality, narrow dimension features 51, 52 and 53 result. The phase shifting assist feature between and on the edges of the flag shaped patterns 16, 17 results in better definition of the edges 58, 59 between the regions 16, 17. Thus, Figs. 4-6 illustrate the application of phase shifting techniques to complex circuit pattern beyond the active regions of the device.

Figs. 7, 8 and 9 illustrate a technique used for layout of complex structures comprising an odd number of intersecting line segments using phase shift masking. Fig. 7 shows a binary mask in a clear field 60 comprising an opaque feature 61 corresponding to a first of intersecting line segments, an opaque feature 62 corresponding to a second of the intersecting line segments, and an opaque feature 63 corresponding to a third of the intersecting line segments. A corner cut-out region 64 is formed according to present technique is described further below. Fig. 8 shows a phase shift mask in an opaque field 70 for formation of the intersecting line segments, and for use in combination with the complementary mask of Fig. 7. The phase shift mask includes 180 degree phase shift region 71, 180 degree phase shift region 72, zero degree phase shift region 73, and zero degree phase shift region 74. As can be seen, the 180 degree phase shift region 71 extends adjacent the line segments corresponding to the regions 61 and 62 and around the corner between regions 61 and 62. Also, the zero degree phase shift region 74 extends adjacent to line segments and 62 and 63 and through the "corner" formed by the 180 degree angle in the intersection two line segments. The phase shift regions 72 and 73 extend along the line segment 63 adjacent one side of the corner and along the other side 61 of the corner, respectively and have opposite phases. An opaque feature is laid out in the corner between the two phase shift regions 72 and 73. The cut-out feature 64 in the binary mask of Fig. 7 tends to expose the artifact which would be created by the phase transition in the corner between phase shift regions 72 and 73.

Fig. 9 shows the simulation of the image printed using the phase shift mask of Fig. 8, with a binary mask of Fig. 7. The features 81, 82, 83 and 84 are nonprinting artifacts of the simulation program. The "T" shaped feature 85 results from the phase shift masking technique with corner cutting. As can be seen, the narrow lines are formed with relatively uniform thickness and straight sides. In the corner 86 which corresponds to the cut-out feature 64 of Fig. 7, the feature 85 is slightly less sharp than in the other corners. The shape of the printed corner could be improved by applying some correction to the cut-out 64 and the shifters 72 and 73.

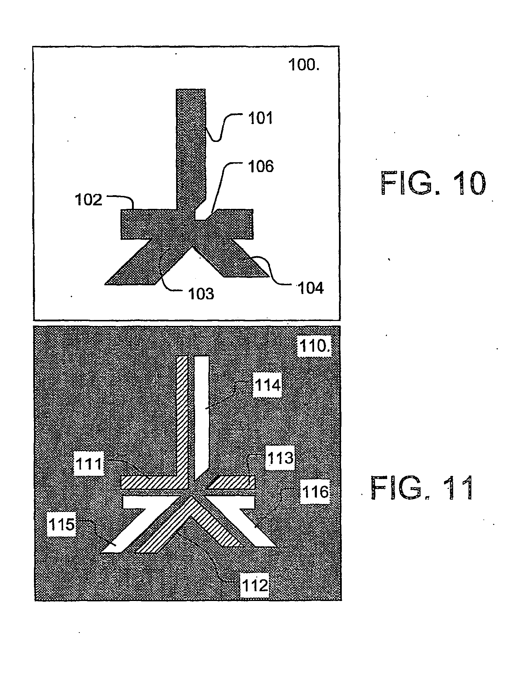

Figs. 10 and 11 illustrates the "comer cutting" technique as applied to a structure comprising five intersecting line segments. Thus, Fig. 10 shows a binary mask 100 including an opaque feature having blocking structure 101 corresponding to a first line segment, blocking structure 102 corresponding to a second line segment, blocking structure 103 corresponding to a third line segment, blocking structure 104 corresponding to the fourth line segment, and blocking structure 105 corresponding to the fifth line segment. A corner cut-out feature 106 is formed between the line segments 101 and 105.

Fig. 11 shows the phase shift mask for use in combination with the binary mask of Fig. 10. The phase shift mask of Fig. 11 is formed in an opaque field 110. 180 degree phase shift regions 111. 112 and 113 are laid out in an alternating fashion as shown Fig. 11. Zero degree phase shift regions 114, 115 and 116 are laid out in a complementary fashion to define the five intersecting line segments. An opaque feature is formed between the phase shift regions 114 and 113. The artifact which would be created by the phase transition between the phase shift regions 113 and 114 is exposed by the cut-out 106 in the binary mask of Fig. 10. In addition, the shape of the opaque feature in the phase shift mask between the phase shift regions 113 the shape of the art-out 106 can also be optimized and 114 can be modified using optical proximity correction techniques to improve that resulting image. The shape of the cut-out 106 can also be optimized.

A structure and a process for controlling phase mismatches on inside corners of complex structures is provided. Inside corner cut-outs are formed on the binary masks to block artifacts of phase transition in the corner, and phase shift regions are adjusted by dividing them into first and second phase shift regions of opposite phase, and reshaping them on inside corners to accommodate and optimize the effects of the inside corner extensions. The corners at which the extensions are applied can be simply decided by applying them to all inside corners, when shapes of the corners are not critical. Alternatively, the corner extensions can be applied only in one corner of a structure having an odd number of intersecting segments. The corner is picked, for example, by selecting an inside corner having the greatest distance from an active area on the device, or an inside corner having a largest angle less than 180 degrees.

The selection of corners for the phase mismatch extensions may affect the assignment of zero and 180 degree phase shift regions. Thus it may be desirable to select the corners for inside corner extensions prior to "coloring" the layout with phase assignments. A first approach to avoiding the corner conflicts is simply to select the phase shift areas in a manner that does not cause a conflict. Of course this is not always possible. Next, the conflicts can be left in regions on the chip where the design rules will tolerate the artifacts caused by the phase mismatch. In one example process, the corner extensions are applied on all inside corners, then the layout is colored to assigned phases, and then corners are rebuilt with optimized shapes. Alternatively, simplified phase assignment can be utilized when all corners are provided with phase mismatch extensions.

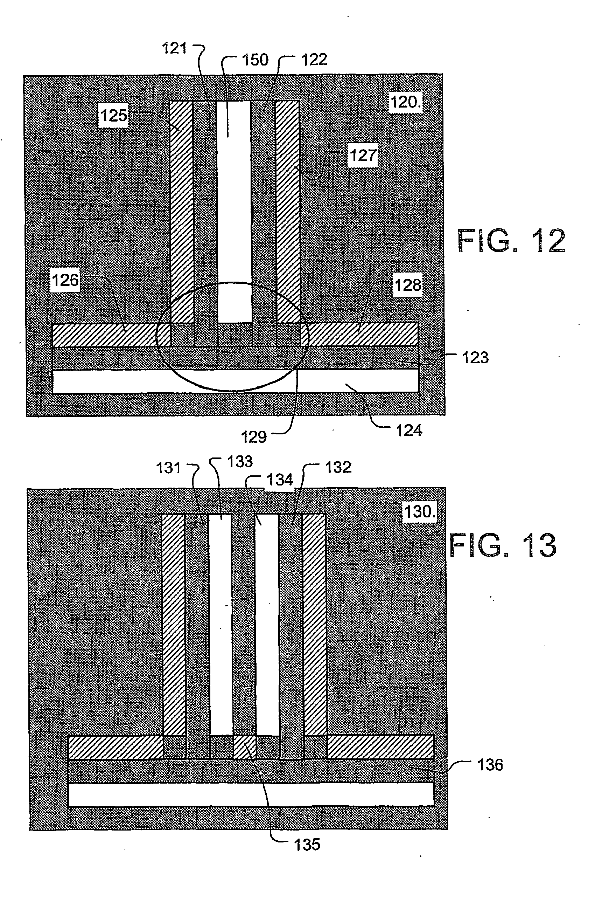

Figs. 12 and 13 illustrate problems encountered in the layout of a so-called double "T" structure. In Fig. 12, a phase shift mask in an opaque field 120 is shown for forming a double "T" structure having vertical line segments 121 and 122 intersecting with horizontal line segment 123. Vertical line segments 121 and 122 are close together, so a single phase shift region 123 is formed between them. In this case, phase shift region 123 is a zero degree phase shift region. Phase shift region 124 beneath the line segment 123 is also a zero degrees phase shift region creating a phase conflict in the region 129 between the vertical line segments 121 and 122. 180 degree phase shift regions 125, 126, 127 and 128 are formed along the line segments in the corners as shown. The shapes of regions 125, 126, 127, 128 have not been optimized in the corner in this example. The phase shift regions do not extend to all the way to the intersection of the line segments in this example. The phase mismatch in the region 129 can result in an aberration image such that the quality of the line segments in that region is reduced. The assumption is that the distance between 121 and 122 is small enough that the printing of the region 129 will not be critical.

Fig. 13 illustrates a double "T" structure with vertical line segments 131 and 132 formed in an opaque field 130. In this case, separate phase shift regions 133 and 134 are formed between the vertical line segments 121 and 122. A 180 degree phase shift region 135 is formed between them along the horizontal line segment 136. This resolves the phase mismatch which would have occurred with the zero degrees a shift region 137 according to the structure of Fig. 12, and allows for higher quality printing of the images. In this case, the corner cutting technique utilizes simple square shape opaque features in the corners, rather than the diagonal shape shown in Figs. 8 and 11. The square shape of Figs. 12 and 13 may be simpler to implement using a layout program in a processor with more limited power.

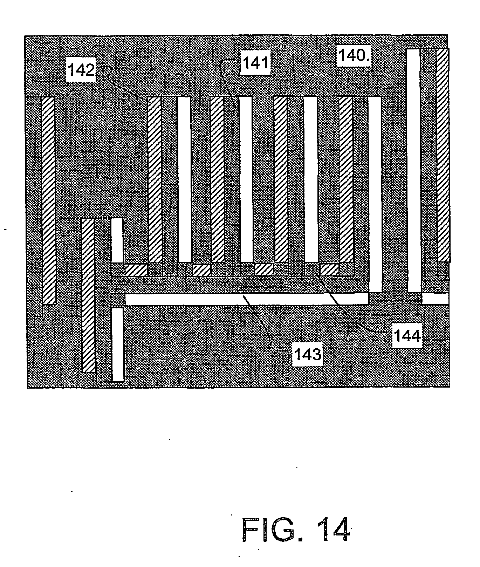

Fig. 14 provides a close-up of a portion of the layout of a phase shift mask in an opaque field for a layer of an integrated circuit structure. As can be seen, a comb shaped structure 141 is formed with zero degree phase shift regions (hatched, e.g. region 142) generally on the upper and left and 180 degree regions (clear, e.g. region 143) generally on the lower and right. All inside corners are blocked with square opaque features (e.g. feature 144) in this example to minimize phase conflicts.

The generation of phase shift masks for a complex structure is a nontrivial processing problem. Automatic assignment of phase shift regions, and addition of optical proximity correction features and corner features for preventing phase shift mismatches as described above are provided in this example to facilitate processing. Three stages in the generation of phase shift mask layouts according to the process which is implemented using a design rule checking programming language (e.g. Vampire (TM) Design Rule Checker provided by Cadence Design Systems, Inc.) as follows:
Definition of the input layers:
   L13 = layer(13 type(0))
      L13 is the original poly layer
   L12 = layer(11 type(0))
   L12 is the original poly layer shifted in the x and y direction by 0.02 micron
Generation of the output layers:
   L2 = geomSize(L13 -0.01 edges)
      size L13 by -0.01 only edges (inner corners are not moved)
   L2_1 = geomAndNot(L13 L2)
   L2_2 = geomSize(L2_1 0.01)
   L3 = geomAndNot(L2_2 L13)
      marker: 0.01 by 0.01 square in inner corners of L13
   L4 = geomSize(L13 0.01)
   L5 = geomSize(L13 0.01.edges)
      size L13 by 0.01 only edges (outer corners are not moved)
   L5_1= geomAndNot(L4 L5)
   L6 = geomAndNot(L5_1 L13)
      marker: 0.01 by 0.01 square at the tips of outer corners
   L6_1 = geomSize(L6 0.14)
   L6_2 = geomsize(L13 0.15 edges)
   L6_3 = geomAndNot(L6_1 L6_2)
   L6_4 = geomSize(L6_3 0.14)
   L6_5 = geomSize(L6_4 -0.14)
      merges any 0.28 and below gaps
   L6_6 = geomSize(L6_5 -0.02)
   L6_7 = geomSize(L6_6 0.02)
      removes any 0.04 and below geometries
   L7 = geomAndNot(L6_7 L13)
      L7 = layer to be removed from phase layer to cut the outer corners
   L3_1 = geomSize(L3 0.15)
   L8 = geomAndNot(L3_1 L13)
      L8 = layer to be removed from phase layer to cut the inner corners
   L8_1 = geomOr(L7 L8)
      add together the layers to be removed from the phase layer
   L8_2 = geomSize(L13 -0.1)
   L8_3 = geomSize(L8_2 0.1)
      removes any 0.2 micron and below geometries
   L8_4 = geomAndNot(L13 L8_3)
      L13 without geometries larger than 0.2 micron
   L9 = geomSize(L8_4 0.15)
   L9_1 = geomAndNot(L9 L8_1)
   L9_2 = geomAndNot(L9_1 L13)
   L9_3 = geomSize(L9_2 -0.03)
   L10 = geomSize(L9_3 0.03)
      -0.03 / 0.03 to remove any geometry below 0.06 micron
      L10 = phase shifter layer (no coloring performed)
   L11 = geomOveriap(L10 L12)
      0 degree phase-shift layer
   L14 = geomAndNot(L10 L11)
      180 degree phase-shift layer

A design rule checker can be utilized to identify all exposed features (i.e. lines) and unexposed features (i.e. spaces between lines) of an input layout that have a size less than a minimum feature dimension. Features subject of the minimum feature dimension may constitute structures or spaces between structures. Different minimum feature dimensions are applied to lines and to spaces in one embodiment. Thus, minimum feature structures can be identified by subtracting slightly more than ½ of a minimum feature dimension for lines from the original size of an input structure. This results in eliminating all structures which have a dimension less than the minimum dimension. The remaining structures can then be reconstituted by adding slightly more than ½ of the minimum dimension back. Minimum dimension structures can then be identified by taking the original input structure and subtracting all structures which result from the reconstitution step. This process can be characterized as performing a size down operation to eliminate small dimension features followed by a size up operation on remaining edges to produce a calculated layout. The small dimension features are then identified performing an "AND NOT" operation between the original layout AND NOT and the calculated layout.

Narrow spaces can be identified by an opposite process. In particular, slightly more than ½ of the minimum feature dimension for spaces is added to the original size of the structure. This added length or width causes structures that are close together to overlap and merge. Next, the remaining structures are reconstituted by subtracting slightly more than ½ of the minimum feature dimension from the sides of structures remaining. Narrow regions are identified by taking the reconstituted remaining structures and subtracting all original structures. Thus, a process can be characterized as performing a size up operation to eliminate small dimension spaces, followed by a size down operation on the remaining edges to produce a calculated layout. The small dimension spaces are then identified by performing an "AND NOT" operation between the calculated layout and the original layout.

The next step in the procedure for automatic generation of phase shift mask layouts involves identifying all corners in the structure. Inside corners and outside corners are identified. Outside corners are blocked to define ends of phase shift regions. Inside corners may result in a phase mismatches discussed above. Inside corners are blocked, and thus provided with an extension of the opaque region, such as a square extension, and a shortening of the phase shift regions so that they do not extend all the way to the inside corner. This square extension is applied in all inside corners, whether a phase mismatch is found or not. Alternatively, the extension is applied only where phase mismatches occur.

Phase shift regions are formed in a simple case, by copying the input structures in the minimum dimension features, and shifting up and to the left for 180 degree (or zero degree) shifters, and down and to the right for zero degree (or 180 degree) shifters. The blocking regions formed for the outside corners cut the shifted regions at the ends of the input structures, and the blocking structures formed on the inside corners cut the shifted regions at the inside corners of the structure to provide well formed phase shift mask definitions. The phase "coloring" can be applied to the resulting phase shift regions in other ways, including manually, so that the zero and 180 degree regions are properly laid out.

The limitation of this simple technique is that the shifts in the X and Y directions need to be carefully chosen if there is any polygon at an angle different from 0 to 90°.

All inside corners are blocked in the example shown in Fig. 14. However, in a preferred system, inside corners for which no phase conflict is encountered would be filled with a phase shift region.

In another embodiment, the inside corner extensions which block phase mismatches, are not applied on inside corners adjacent active regions of devices that are near the corners, if a choice is possible. For structures having an odd number of segments intersecting, the location of the phase mismatch, and application of the corner extension, can be chosen at the angle farthest from the active regions in the device, or at the largest angle.

Once the inside corner extensions are identified, the extensions can be optimally shaped to improve the resulting exposure pattern, such as by changing the squares to diagonally shaped regions shown in Figs. 8 and 11. Other principles of optical proximity correction can be applied to enhance the shapes of the inside corner extensions. Likewise, the phase shift regions can be shaped adjacent the inside corners to enhance performance. In one example system transitions may be enhanced between the phase shift regions by placing a 90 degree phase shift region between conflicting zero and 180 degree phase shift regions.

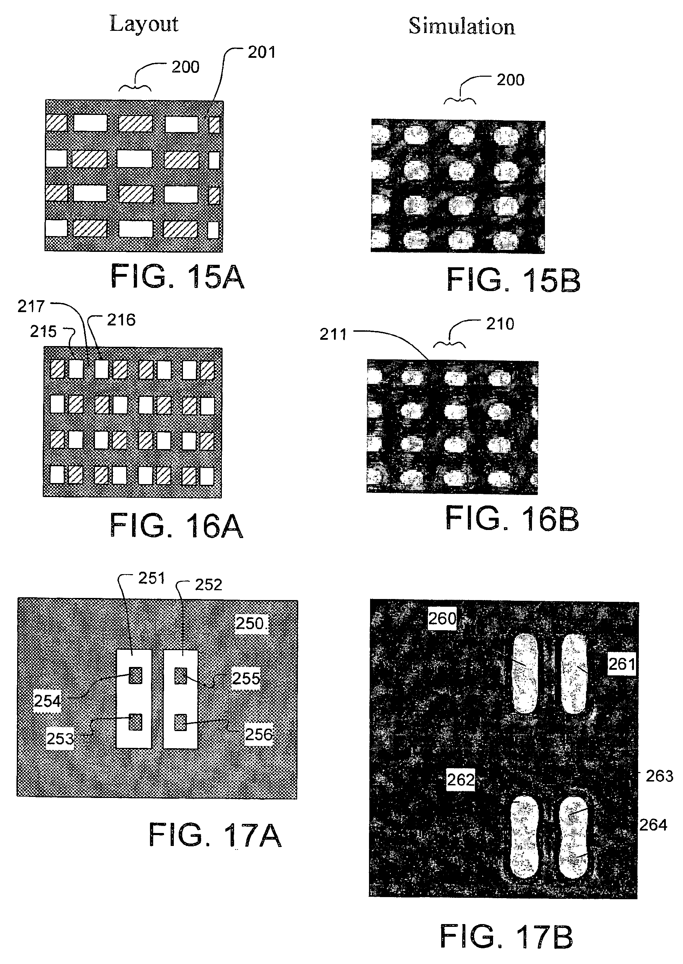

Figs. 15A and 15B illustrate a prior art technique for laying out an array of dense shapes, such as a capacitor plate array in the layout of a dynamic random access memory device. A phase shift mask as shown in Fig. 15A is used to form the array. The phase shift mask includes a column 200 of alternating phase transparent areas within an opaque field 201. Likewise adjacent columns alternate in phase in a complementary manner as shown. This results in the printing of lines on transitions between the alternating phase shift areas and exposing regions inside the phase shift regions. Fig. 15B illustrates the simulation of the exposure pattern. As can be seen, a dense array of oval patterns is caused by the layout of Fig. 15A. For a denser array, it is desirable to make the exposed patterns more rectangular in shape.

Fig. 16A illustrates an adjustment to the phase shift layout according to the present invention to make the exposed patterns more rectangular. According to this technique, the phase shift regions have been adjusted so that they consist of a first phase shift area 215 and a second phase shift area 216 having the same phase with an opaque sub-resolution feature 217 in between. Likewise, all of the phase shift regions have been split into two phase shift regions as shown with sub-resolution features in between. Note that the assist feature which divides the phase shift region is not necessarily smaller than the phase shift region. Lines are printed at the phase transitions, and the sub-resolution features between the like-phase regions do not print.

The resulting pattern is shown in Fig. 16B, where the exposure shows features having much straighter sides and covering much greater area than those of Fig. 15B. In the simulation plot of Fig. 16B, the dark outlines, such as line 211, illustrate the final contour of the exposed region. Thus, a technique for improving the image which result from use of phase shift areas involves adjusting a phase shift area having a particular phase into a first phase shift area and a second phase shift area having the same particular phase and adding a sub-resolution feature in between.

Figs. 17A and 17B illustrate the use of sub-resolution features within the phase shift regions according to an example which is presented for illustration. In Fig. 17A, an opaque field 250 is shown with a first phase shift region 251 and a second phase shift region 252 having an opposite phase. Sub-resolution assist features 253 and 254 are formed within the phase shift region 251. Sub-resolution assist features 255 and 256 are formed within the phase shift region 252. As can be seen, the phase shift regions 251 and 252 have respective perimeters. The sub-resolution features 253, 254, 255, 256 are inside of the phase shift regions and do not contact the perimeters in this example.

Fig. 17B shows simulation of the exposure patterns resulting from the phase shift mask of Fig. 17A. In the top, images 260 and 261 are shown which correspond to the use of the phase shift mask of Fig. 17A. Images 262 and 263 correspond to the use of the phase shift mask of Fig. 17A without the sub-resolution assist features 253-256. As can be seen, with the sub-resolution assist features 253-256, the lines are much straighter and the exposure patterns are much more uniform. According to one technique, the sub-resolution features are placed within the phase shift regions by first simulating the exposure patterns without the sub-resolution assist features. Hot spots, such as hot spot 264 in the simulation image 263 or other anomalies, are identified. Sub-resolution features are then placed over the anomalies. Thus, sub-resolution feature 255 corresponds to the hot spot 264.

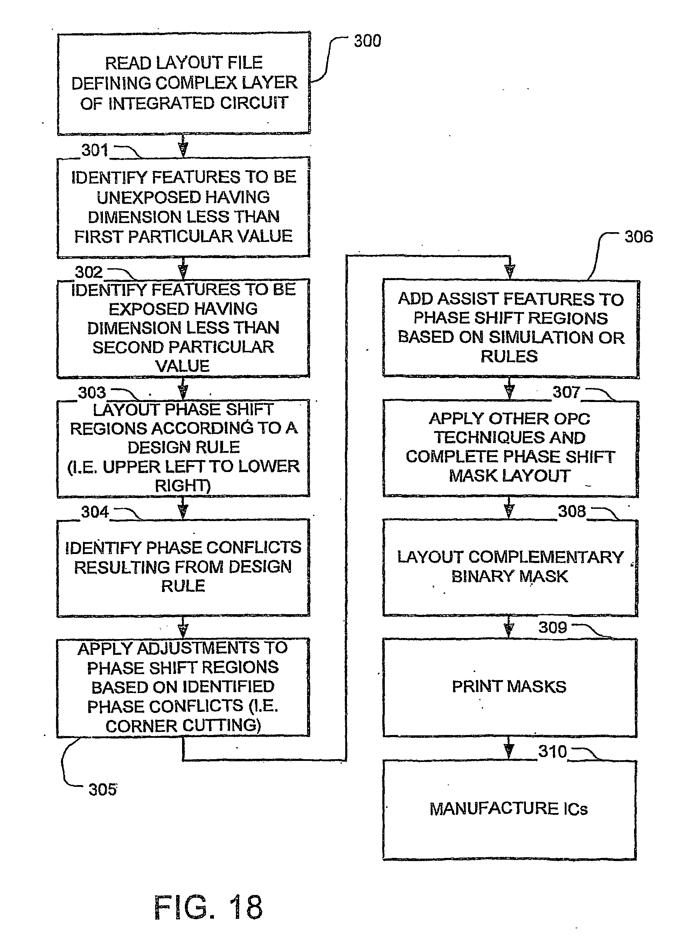

The techniques for improving phase shift masking for complex layouts outlined above are combined into a process for producing phase shift layout data and manufacturing phase shift masks for complex layouts, as shown in Fig. 18. The process is also extended to the manufacturing of integrated circuits with improved structures. Thus, according to the present invention, the manufacturing process involves reading a layout file which defines a complex layer of an integrated circuit (step 300). For example, in one embodiment the layer comprises polysilicon or another conductive material used in transition gates and interconnect structures. Next, features to be left unexposed by the mask are identified which have a dimension less than a first particular value (step 301). Then, features to be exposed and having a dimension less the second particular value are identified (step 302). The first and second particular values may be the same value or different, as suits the particular implementation.

Next, the process involves laying out phase shift regions for the identified features according to a design rule (step 303). One example design rule involves laying out phase shift regions having a zero degree phase (or 180 degree phase) to the upper left, and a phase shift regions having the opposite phase, such as 180 degree phase (or zero degree phase) to lower right This simple phase shift layout rule results in phase conflicts, where adjacent phase shift regions have the same phase so phase transitions do not occur. Any other phase assignment technique can be used. The phase conflicts are identified in a next step (step 304). Adjustments are applied to the phase shift regions based on identified phase conflicts (step 305). For example, the corner cutting technique described with respect to Figs. 7-11 is applied. In a next step, the exposure pattern is simulated and assist features are added to the phase shift regions based on the simulation (step 306). Rather than using simulation for placement of sub-resolution assist features, the locations of the sub-resolution features can be determined based on design rules. For example, one design rule is to place place a 0.1 µm square assist feature, 0.2 µm away from the edge of the phase shift region. Thus, phase shift regions may be adjusted using sub-resolution assist features within the perimeter of the phase shift region or by dividing the phase shift region as described with reference to Figs. 16A and 17A.

In a next step, other optical proximity correction techniques are applied and the phase shift mask layout is completed (step 307). A complementary mask is then laid out, including the corner cut-outs as necessary for intersecting line segments and the like (step 308).

With the completed phase shift and complementary mask layouts, the masks are printed using techniques known in the art (step 309). See, United States Patent Nos. 6,096,458; 6,057,063; 5,246,800; 5,472,814; and 5,702,847, which provide background material for phase shift mask manufacturing. Finally, integrated circuits are manufactured using the resulting phase shift masks (step 310).

Overall, the embodiments described provide a solution for applying phase shift masks extensively in integrated circuit layouts. This provides for shrinking entire layouts or significant portions of layouts. The process involves first identifying features using a computer program to define any features that have a dimension which is smaller than a specified minimum dimension. Also, the process is applied to identify spaces between features which are smaller than a minimum dimension. The minimum dimension for spacing may be different than the minimum dimension for structures. After detection of features smaller than a minimum dimension, phase shift regions are assigned. Non-printing phase shift regions can be used for providing greater contrast in narrow isolated spaces. Inside corner extensions to block phase conflicts are added where necessary. Complementary trim masks are generated using established techniques. Finally, optical proximity correction modeling is used to optimize the shapes being implemented.

Embodiments of the invention also provides techniques for applying phase shifting to specific shapes, such as "T" shapes, "Y" shapes, "U" shapes and "double T" shapes.

Optical proximity correction can be applied to the resulting phase shifted layouts. Serifs can be added to corners, line sizes can be adjusted, hammer heads can be added, phase shift areas can be sized, and assist opaque bars may be added to phase shift areas, using optical proximity correction modeling techniques.

The foregoing description of various embodiments of the invention have been presented for purposes of illustration and description. The description is not intended to limit the invention to the precise forms disclosed. Many modifications and arrangements of the invention will be apparent to people skilled in the art defined by the scope of the appended claims.

### CLAUSES

1. A method, comprising:
   laying out phase shift regions to produce a phase shift mask having phase shift areas to define features having a dimension less than a particular feature size; and
   applying an adjustment to one or more of the phase shift regions in the phase shift mask to correct for the phase conflicts due to proximity of phase shift regions having the same phase.
2. The method of clause 1, including identifying the features in a pattern having a dimension less than a particular feature size.
3. The method of clause 2, including identifying features includes reading a layout file which identifies features of the pattern, and processing the layout file.
4. The method of clause 1, wherein said adjustment to the shape comprises dividing a phase shift region having a first phase into a first phase shift region having the first phase and a second phase shift region having a second phase, and adding an opaque feature to the phase shift mask separating the first and second phase shift regions; and including
   laying out a complementary mask including an opaque feature preventing exposure of the features to be exposed using the first and second phase shift regions in the phase shift mask, the opaque feature including a cut-out over the opaque feature separating the first and second phase shift regions to expose any feature resulting from the phase transition between the first and second phase shift regions.
5. The method of clause 1, wherein the pattern includes one or more features having a feature size equal to a critical dimension, and wherein said critical dimension is smaller than said particular feature size.
6. The method of clause 1, wherein said phase shift mask includes an opaque field, and said phase shift regions include a plurality of transparent regions having a first phase within said opaque field, and a plurality of complementary transparent regions having a second phase approximately 180 degrees out of phase with respect to the first phase, within said opaque field.
7. The method of clause 1 including adding sub-resolution features inside one or more phase shift regions in the phase shift mask.
8. The method of clause 1, including dividing a phase shift region having a first phase into first and second phase shift regions having the first phase and adding a sub-resolution feature between the first and second phase shift regions.
9. The method of clause 1, including adding sub-resolution features inside a particular phase shift region in the phase shift mask, where the particular phase shift region has a perimeter and the sub-resolution feature is inside and does not contact said perimeter.
10. The method of clause 1, including adding sub-resolution features to the phase shift mask.
11. The method of clause 1, wherein said pattern includes exposed regions and unexposed regions, and wherein said features having less than the particular feature size include unexposed regions between exposed regions, and including laying out phase shift regions in the phase shift mask to assist definition of edges of said unexposed regions between exposed regions.
12. The method of clause 1, including laying out a complementary mask comprising opaque regions and transparent regions defining features having dimensions greater than the particular feature size.
13. The method of clause 11, wherein said complementary mask comprises a binary mask.
14. The method of clause 11, including producing a machine readable layout file defining the layout of the phase shift mask and of the complementary mask.
15. The method of clause 11, including producing the phase shift mask and the complementary mask.
16. The method of clause 14, including producing an integrated circuit using the phase shift mask and the complementary mask.
17. A method, comprising:
   processing a pattern for a photolithographic mask that defines a layer, wherein said pattern defines exposed regions and unexposed regions in the layer;
   identifying exposed regions in the pattern having a dimension less than a first feature size;
   identifying unexposed regions in the pattern having a dimension less than a second feature size;
   laying out phase shift regions in an opaque field using a layout rule for the identified exposed regions to produce a phase shift mask having phase shift areas with respective shapes, including regions in the phase shift mask which result in phase conflicts using the layout rule;
   applying an adjustment to the shape of one or more of the phase shift regions in the phase shift mask to correct for the phase conflicts; and
   laying out phase shift regions in the phase shift mask for the identified unexposed regions to assist definition of edges of said unexposed regions between exposed regions.
18. The method of clause 17, said identifying exposed regions includes reading a layout file which identifies dimensions of the exposed regions in the pattern, and processing the layout file.
19. The method of clause 17, wherein said adjustment to the shape comprises dividing a phase shift region having a first phase into a first phase shift region having the first phase and a second phase shift region having a second phase, and adding an opaque feature to the mask separating the first and second phase shift regions; and including
   laying out a complementary mask including an opaque feature preventing exposure of the features to be exposed using the first and second phase shift regions in the phase shift mask, the opaque feature including a cut-out over the opaque feature separating the first and second phase shift regions to expose any feature resulting from the phase difference in the one excepted corner between the first and second phase shift regions.
20. The method of clause 17, wherein the pattern includes one or more exposed regions having a feature size equal to a critical dimension, and wherein said critical dimension is smaller than said first feature size.
21. The method of clause 17, wherein said phase shift mask includes an opaque field, a plurality of transparent regions having a first phase within said opaque field, and a plurality of complementary transparent regions having a second phase approximately 180 degrees out of phase with respect to the first phase, within said opaque field.
22. The method of clause 17, including adding sub-resolution features inside one or more phase shift regions in the phase shift mask.
23. The method of clause 17, including dividing a phase shift region having a first phase into first and second phase shift regions having the first phase and adding a sub-resolution feature between the first and second phase shift regions.
24. The method of clause 17, including adding sub-resolution features inside a particular phase shift region in the phase shift mask, where the particular phase shift region has a perimeter and the sub-resolution feature is inside and does not contact said perimeter.
25. The method of clause 17, including adding sub-resolution features to the phase shift mask.
26. The method of clause 17, including laying out a complementary mask comprising opaque regions and transparent regions defining features having dimensions greater than the particular feature size.
27. The method of clause 26, wherein said complementary mask comprises a binary mask.
28. The method of clause 17, wherein the first and second feature sizes are equal.
29. The method of clause 17, wherein the first and second feature sizes are not equal.
30. The method of clause 26, including producing a machine readable layout file defining the layout of the phase shift-mask and of the complementary mask.
31. The method of clause 26, including producing the phase shift mask and the complementary mask.
32. The method of clause 31, including producing an integrated circuit using the phase shift mask and the complementary mask.
33. A method, comprising:
   identifying features of a pattern for a layer to be formed using a photolithographic mask, the pattern consisting of an intersection of an odd number of line segments, the intersection defining a plurality of corners; and
   laying out phase shift regions for the identified features to produce a phase shift mask, the phase shift mask having phase shift regions extending adjacent to the line segments and around the corners in all of the plurality of corners except one, and in the one corner including a first phase shift region having the first phase extending adjacent the line segment on one side of said one corner, a second phase shift region having a second phase extending adjacent the line segment on the other side of said one corner; and
   laying out a complementary mask including an opaque feature preventing exposure of the intersecting line segments to be exposed using the phase shift mask, the opaque feature including a cut-out in the one excepted corner to expose any feature resulting from the phase difference in the one excepted corner between the first phase shift region and the second phase shift region.
34. The method of clause 33, including an opaque feature in the one corner between the first and second phase shift regions.
35. The method of clause 33, said step of identifying features includes reading a layout file which identifies features of the pattern, and processing the layout file.
36. The method of clause 33, wherein said phase shift mask includes an opaque field, and said phase shift regions include a plurality of transparent regions having said first phase within said opaque field, and a plurality of complementary transparent regions having said second phase within said opaque field.
37. The method of clause 33, wherein said first phase is 180 degrees out of phase with respect to said second phase.
38. The method of clause 33, including laying out a complementary mask comprising opaque regions and transparent regions defining features having dimensions greater than the particular feature size.
39. The method of clause 33, including adding sub-resolution features inside one or more phase shift regions in the phase shift.
40. The method of clause 33, including dividing a phase shift region having a first phase into first and second phase shift regions having the first phase and adding a sub-resolution feature between the first and second phase shift regions.
41. The method of clause 33, including adding sub-resolution features inside a particular phase shift region in the phase shift mask, where the particular phase shift region has a perimeter and the sub-resolution feature is inside and does not contact said perimeter.
42. The method of clause 33, including adding sub-resolution features to the phase shift mask.
43. The method of clause 33, including identifying the one excepted corner according to a design rule.
44. The method of clause 43, wherein the intersection is near an active region on the integrated circuit, and one excepted corner is selected so that it is farther from the active region than the other corners in the plurality of corners.
45. The method of clause 33, wherein the plurality of corners define respective angles of less than 180 degrees, and the one excepted corner defines the largest angle of the respective angles.
46. The method of clause 33, wherein said complementary mask comprises a binary mask.
47. The method of clause 33, including producing a machine readable layout file defining the layout of the phase shift mask and of the complementary mask.
48. The method of clause 33, including producing the phase shift mask and the complementary mask.
49. The method of clause 48, including producing an integrated circuit using the phase shift mask and the complementary mask.
50. A method, comprising:
   identifying features having a dimension less than a particular feature size in a pattern for a layer to be formed using a photolithographic mask;
   laying out phase shift regions to produce a phase shift mask having phase shift regions for use in defining the features;
   simulating exposure characteristics of the phase shift mask to identify locations of anomalous exposure features in the phase shift regions; and
   adding sub-resolution features within one or more of the phase shift regions in the phase shift mask in the locations of the anomalous exposure features.
51. The method clause said step of identifying features includes reading a layout file which identifies features of the pattern, and processing the layout file.
52. The method of clause 50, wherein said phase shift mask includes an opaque field, and said phase shift regions include a plurality of transparent regions having said first phase within said opaque field, and a plurality of complementary transparent regions having said second phase within said opaque field.
53. The method of clause 50, wherein the pattern includes one or more exposed regions having a feature size equal to a critical dimension, and wherein said critical dimension is smaller than said particular feature size.
54. The method of clause 50, wherein adding sub-resolution features within one or more of the phase shift regions includes dividing a phase shift region having a first phase into first and second phase shift regions having the first phase and adding a sub-resolution feature between the first and second phase shift regions.
55. The method of clause 50, wherein adding sub-resolution features within one or more of the phase shift regions includes adding sub-resolution features inside a particular phrase shift region in the phase shift mask, where the particular phase shift region has a perimeter and the sub-resolution feature is inside and does not contact said perimeter.
56. The method of clause 50, including laying out a complementary mask comprising opaque regions and transparent regions defining features having dimensions greater than the particular feature size.
57. The method of clause 56, wherein said complementary mask comprises a binary mask.
58. The method of clause 56, including producing a machine readable layout file defining the layout of the phase shift mask and of the complementary mask.
59. The of clause 56, including producing the phase shift and them complementary mask.
60. The method of clause including producing an integrated circuit using the phase shift mask and the complementary mask.
61. A method, comprising:
   identifying features in a pattern for a layer to be formed using a photolithographic mask, the pattern having a dimension less than a particular feature size; and
   laying out phase shift regions to produce a phase shift mask having phase shift regions; and
   adding sub-resolution features within one or more of the phase shift regions in the phase shift mask in locations determined according to a design rule.
62. The method of clause 61, said step of identifying features includes reading a layout file which identifies features of the pattern, and processing the layout file.
63. The method of clause 61, wherein said phase shift mask includes an opaque field, and said phase shift regions include a plurality of transparent regions having said first phase within said opaque field, and a plurality of complementary transparent regions having said second phase within said opaque field.
64. The method of clause 61, wherein the pattern includes one or more exposed regions having a feature size equal to a critical dimension, and wherein said critical dimension is smaller than said particular feature size.
65. The method of clause 61, wherein adding sub-resolution features within one or more of the phase shift regions includes dividing a phase shift region having a first phase into first and second phase shift regions having the first phase and adding a sub-resolution feature between the first and second phase shift regions.
66. The method of clause 61, wherein adding sub-resolution features within one or more of the phase shift regions includes adding sub-resolution features inside a particular phase shift region in the phase shift mask, where the particular phase shift region has a perimeter and the sub-resolution feature is inside and does not contact said perimeter.
67. The method of clause 61, including laying out a complementary mask comprising opaque regions and transparent regions defining features having dimensions greater than the particular feature size.
68. The method of clause 67, wherein said complementary mask comprises a binary mask.
69. The method of clause 67, including producing a machine readable layout file defining the layout of the phase shift mask and of the complementary mask.
70. The method of clause 67, including producing the phase shift mask and the complementary mask.
71. The method of clause 69, including producing an integrated circuit using the phase shift mask and the complementary mask.

## Claims

1. A method, comprising:
laying out phase shift regions (215, 216) to produce a phase shift mask having phase shift regions to define features, said phase shift regions having sides which along with complementary sides of phase shift regions define phase transitions for definition of corresponding features;
applying an adjustment to one or more of the phase shift regions in the phase shift mask wherein said adjustment divides the one or more phase shift regions into two or more phase shift regions, and includes an opaque feature which does not touch said side that defines a phase transition for definition of a corresponding feature,
said adjustment to the phase shift region comprises dividing a particular phase shift region having a first phase along a line substantially parallel to said side that defines a phase transition for definition of the corresponding feature into a first phase shift region having the first phase and a second phase shift region having the first phase, and adding an opaque sub-resolution feature to the phase shift mask separating the first and second phase shift regions.

2. The method of claim 1, including identifying the features in a pattern having a dimension less than a particular feature size.

3. The method of claim 2, including reading a layout file which identifies features of the pattern, and processing the layout file.

4. The method of any one of claims 2 or 3, wherein the pattern includes one or more features having a feature size equal to a critical dimension, and wherein said critical dimension is smaller than said particular feature size.

5. The method of claim 2, 3 or 4, wherein said pattern includes exposed regions and unexposed regions, and wherein said features having less than the particular feature size include unexposed regions between exposed regions, and including laying out phase shift regions in the phase shift mask to assist definition of edges of said unexposed regions between exposed regions.

6. The method of claim 2, 3, 4 or 5, including laying out a complementary mask comprising opaque regions and transparent regions defining features having dimensions greater than the particular feature size.

7. The method of any one of the preceding claims, wherein said phase shift mask includes an opaque field, and said phase shift regions include a plurality of transparent regions having a first phase within said opaque field, and a plurality of complementary transparent regions having a second phase approximately 180 degrees out of phase with respect to the first phase, within said opaque field.

## Patentansprüche

1. Verfahren, das Folgendes umfasst:
Anordnen von Phasenverschiebungsgebieten (215, 216) zum Erzeugen einer Phasenverschiebungsmaske mit Phasenverschiebungsgebieten zum Definieren von Strukturmerkmalen, wobei die Phasenverschiebungsgebiete Seiten aufweisen, die zusammen mit komplementären Seiten von Phasenverschiebungsgebieten Phasenübergänge für eine Definition von entsprechenden Strukturmerkmalen definieren;
Anwenden einer Justierung auf eines oder mehrere der Phasenverschiebungsgebiete in der Phasenverschiebungsmaske, wobei die Justierung das eine oder die mehreren Phasenverschiebungsgebiete in zwei oder mehr Phasenverschiebungsgebiete unterteilt und ein undurchsichtiges Strukturmerkmal enthält, das die Seite nicht berührt, die einen Phasenübergang für eine Definition eines entsprechenden Strukturmerkmals definiert,
wobei die Justierung an dem Phasenverschiebungsgebiet das Unterteilen eines bestimmten Phasenverschiebungsgebiets mit einer ersten Phase entlang einer Linie im Wesentlichen parallel zu der Seite, die einen Phasenübergang für eine Definition des entsprechenden Strukturmerkmals definiert, in ein erstes Phasenverschiebungsgebiet mit der ersten Phase und ein zweites Phasenverschiebungsgebiet mit der ersten Phase und das Hinzufügen eines undurchsichtigen Unterauflösungs-Strukturmerkmals zu der Phasenverschiebungsmaske, das erste und zweite Phasenverschiebungsgebiet trennend.

2. Verfahren nach Anspruch 1, mit dem Identifizieren der Strukturmerkmale in eine Struktur mit einer Abmessung unter einer bestimmten Strukturmerkmalsgröße.

3. Verfahren nach Anspruch 2, mit dem Lesen einer Anordnungsdatei, die Strukturmerkmale der Struktur identifiziert, und Verarbeiten der Anordnungsdatei.

4. Verfahren nach einem der Ansprüche 2 oder 3, wobei die Struktur ein oder mehrere Strukturmerkmale mit einer Strukturmerkmalsgröße gleich einer kritischen Abmessung enthält und wobei die kritische Abmessung kleiner ist als die bestimmte Strukturmerkmalsgröße.

5. Verfahren nach Anspruch 2, 3 oder 4, wobei die Struktur belichtete Gebiete und unbelichtete Gebiete enthält und wobei die Strukturmerkmale mit einer Größe kleiner als der bestimmten Strukturmerkmalsgröße unbelichtete Gebiete zwischen belichteten Gebieten enthalten, und mit dem Anordnen von Phasenverschiebungsgebieten in der Phasenverschiebungsmaske, um eine Definition von Rändern der unbelichteten Gebiete zwischen belichteten Gebieten zu unterstützen.

6. Verfahren nach Anspruch 2, 3, 4 oder 5, mit dem Anordnen einer komplementären Maske, die undurchsichtige Gebiete und transparente Gebiete umfasst, Strukturmerkmale mit Abmessungen definierend, die größer sind als die bestimmte Strukturmerkmalsgröße.

7. Verfahren nach einem der vorhergehenden Ansprüche, wobei die Phasenverschiebungsmaske ein undurchsichtiges Feld enthält und die Phasenverschiebungsgebiete mehrere transparente Gebiete mit einer ersten Phase innerhalb des undurchsichtigen Felds enthält, und mehrere komplementäre transparente Gebiete mit einer zweiten Phase ungefähr 180 Grad außer Phase bezüglich der ersten Phase, innerhalb des undurchsichtigen Felds.

## Revendications

1. Procédé, comprenant :
l'agencement de régions de déphasage (215, 216) afin de produire un masque de déphasage ayant des régions de déphasage destinées à définir des caractéristiques, lesdites régions de déphasage ayant des côtés qui, en association avec des côtés complémentaires de régions de déphasage, définissent des transitions de phase pour la définition de caractéristiques correspondantes ;
l'application d'un ajustement à une ou plusieurs des régions de déphasage du masque de déphasage, ledit ajustement divisant lesdites une ou plusieurs régions de déphasage en deux ou plusieurs régions de déphasage, et comprenant une caractéristique opaque qui ne touche pas ledit côté définissant une transition de phase pour la définition d'une caractéristique correspondante,
ledit ajustement de la région de déphasage comprenant la division d'une région de déphasage particulière ayant une première phase le long d'une droite sensiblement parallèle audit côté définissant une transition de phase pour la définition de la caractéristique correspondante, en une première région de déphasage ayant la première phase et une seconde région de déphasage ayant la première phase, et l'ajout d'une caractéristique de sous-résolution opaque au masque de déphasage séparant les première et seconde régions de déphasage.

2. Procédé selon la revendication 1, comprenant l'identification des caractéristiques dans un motif ayant une dimension inférieure à une taille de caractéristique particulière.

3. Procédé selon la revendication 2, comprenant la lecture d'un fichier d'agencement qui identifie des caractéristiques du motif, et le traitement du fichier d'agencement.

4. Procédé selon l'une quelconque des revendications 2 ou 3, dans lequel le motif comprend une ou plusieurs caractéristiques ayant une taille de caractéristique égale à une dimension critique, et dans lequel ladite dimension critique est inférieure à ladite taille de caractéristique particulière.

5. Procédé selon la revendication 2, 3 ou 4, dans lequel ledit motif comprend des régions exposées et des régions non exposées, et dans lequel lesdites caractéristiques ayant une taille inférieure à la taille de caractéristique particulière comprennent des régions non exposées entre des régions exposées, et comprenant l'agencement de régions de déphasage du masque de déphasage afin d'aider à la définition de bords desdites régions non exposées entre des régions exposées.

6. Procédé selon la revendication 2, 3, 4 ou 5, comprenant l'agencement d'un masque complémentaire comprenant des régions opaques et des régions transparentes définissant des caractéristiques ayant des dimensions supérieures à la taille de caractéristique particulière.

7. Procédé selon l'une quelconque des revendication précédentes, dans lequel ledit masque de déphasage comprend un champ opaque, et lesdites régions de déphasage comprennent une pluralité de régions transparentes ayant une première phase à l'intérieur dudit champ opaque, et une pluralité de régions transparentes complémentaires ayant une seconde phase déphasée d'environ 180 degrés par rapport à la première phase, à l'intérieur dudit champ opaque.
